# EUROPÄISCHE PATENTANMELDUNG

(11) **EP 0 986 095 A2**
(43) Veröffentlichungstag der Anmeldung: **15.03.2000**
(21) Anmeldenummer: 99116796.6
(22) Anmeldetag: 01.09.1999
(51) Int. Cl.: H01L 21/225, H01L 21/28, H01L 27/108, H01L 27/11, H01L 29/92

(54) **Schichtanordnung mit einer Materialschicht und einer im Bereich der Korngrenzen der Materialschicht angeordneten Diffusionsbarrierenschicht, und Verfahren zur Herstellung derselben**

(30) Priorität: 08.09.1998 DE 19841006
(71) Anmelder: SIEMENS AKTIENGESELLSCHAFT, 80333 München (DE)
(72) Erfinder: Dehm, Christine, Dr., 81543 München (DE); Mazure-Espejo, Carlos, Dr., 81667 München (DE)

(57) **Zusammenfassung**

Beschrieben wird eine Schichtanordnung mit einer Materialschicht und einer Diffusionsbarriere gegen diffundierende Materialkomponenten, die im Bereich der Schichtgrenze der Materialschicht angeordnet ist, wobei die Diffusionsbarriere überwiegend in den Korngrenzen der Materialschicht ausgebildet ist.

## Beschreibung

Die Erfindung betrifft eine Schichtanordnung mit einer Materialschicht und einer Diffusionsbarriere gegen diffundierende Materialkomponenten sowie ein Verfahren zur Herstellung einer Diffusionsbarriere gegen diffundierende Materialkomponenten.

Es ist ein häufiges Problem, daß bei Herstellungs- oder Betriebsprozessen unerwünschte Diffusionseffekte von Marterialkomponenten auftreten, die unterbunden werden sollen. Häufig verwendetes Mittel hierzu ist die Vorsehung von Diffusionsbarrieren.
Speziell in der Halbleitertechnologie finden beispielsweise häufig Materialschichten Anwendung, die einen Erzeugungs- oder Nachbehandlungsschritt bei hoher Temperatur erfordern. Dies trifft z.B. auf ferroelektrische Materialien oder dielektrische Materialien mit hoher Dielektrizitätskonstante zu, wie sie beispielsweise als dielektrische oder ferroelektrische Schichten in Kondensatoren vorkommen. In diesem speziellen Fall können z.B. Materialien wie SBT SrBi₂Ta₂O₉, SBTN SrBi₂(Ta₁₋ₓNbₓ)₂O₉, PZT PbₓZr₁₋ₓTiO₃ oder BST BaₓSr₁₋ₓTiO₃ Verwendung finden. Diese Materialien sind beispielsweise aus DE 196 40 273 und aus DE 196 40 240 bekannt. Es können aber auch Materialien wie Ta₂O₅, TiO₂, Oxide oder Oxi-Nitride verwendet werden. Zur Herstellung von Kondensatoren für integrierte Schaltkreise unter Verwendung gerade der o.g. ferroelektrischen Materialien oder dielektrischen Materialien mit hoher Dielektrizitätskonstante sind Temperaturen bis zu 800°C für Temperschritte unter Sauerstoff-Atmosphäre notwendig.

Solch hohe Temperaturen unter Anwesenheit von Sauerstoff begünstigen die Diffusion von Materialkomponenten aus diesen Materialschichten in angrenzende Schichten sowie eine Diffusion des zur Temperung nötigen Sauerstoffs. So können beispielsweise Oxide durch unerwünschte Diffusionsprozesse entweichen, wie Bi₂O₃ oder PbO, die relativ leicht in angrenzende Materialschichten hineindiffundieren können. Auch die Diffusion des Sauerstoffs selbst ist unter solchen Bedingungen stark begünstigt. Es kommt hinzu, daß gerade bei den verwendeten höheren Temperaturen Reaktionen der entweichenden Komponenten mit den angrenzenden Schichten begünstigt werden. So besteht die Gefahr, daß die entweichenden Materialkomponenten weitere Arbeitsschritte nachhaltig beeinträchtigen oder angrenzende Schichten schädigen. So kann z.B. eine angrenzende Elektrodenschicht durch entweichende Oxide oder Sauerstoff oxidiert werden und damit eine leitende Verbindung unterbrochen werden oder es kann eine Diffusion durch die Elektrodenschicht, z.B. eine Platinschicht, erfolgen, wobei die Oxide oder Sauerstoff mit an die Elektrode angrenzenden Haftvermittlern oder Isolationsschichten wie SiO₂ reagieren können. Es kann natürlich auch zu unerwünschten Diffusionsprozessen in umgekehrter Richtung kommen, d.h. von Materialkomponenten aus angrenzenden Schichten in die vorgenannten Materialschichten hinein.

Ähnliche Probleme treten überall dort auf, wo aus Materialschichten Materialkomponenten durch Diffusion entweichen können, oder in bestimmten Gebieten oder Räumen leicht diffundierende, unerwünschte Materialkomponenten vorhanden sind, und sich in der Umgebung Schichten, Bereiche, Gase oder Räume, wie z.B. Materialschichten, Leiterbereiche, Beschichtungs- oder Analysekammern, befinden, die durch die diffundierenden Materialkomponenten gestört oder geschädigt werden können. Somit ist die Anwendung der Erfindung nicht auf Halbleiteranordnungen mit dielektrischen oder ferroelektrischen Schichten beschränkt, sondern die erfindungsgemäße Idee kann in allen Bereichen Einsatz finden, in denen eine Diffusion unerwünschter Materialkomponenten verhindert werden soll.

Es ist bereits aus R.E. Jones, S.B. Desu: Process Integration for Nonvolatile Ferroelectric Memory Fabrication, MRS Bulletin, Juni 1996, S. 55 - 58 bekannt, daß TiN oder TaN als Barrierenmaterialien speziell für Halbleiteranordnungen möglich sind. Diese sind jedoch gerade bei hohen Temperaturen nicht sonderlich stabil und werden besonders durch Oxide nach relativ kurzer Zeit angegriffen. Andererseits sind auch Titanoxid oder Zirkoniumoxid als Diffusionsbarriere gegen Oxiddiffusion aus oxidhaltigen Materialschichten vorgeschlagen. Dabei ist jedoch immer noch die Verwendung einer separaten Barrierenschicht vorgesehen, um die unerwünschten Diffusionsprozesse zu unterdrücken.

Aufgabe der vorliegenden Erfindung ist es daher, eine verbesserte Möglichkeit zur Verhinderung von Diffusionsprozessen bereitzustellen. Diese Aufgabe wird gelöst durch die Merkmale der Ansprüche 1 und 12.
Es hat sich herausgestellt, daß die Ausbildung einer Diffusionsbarriere überwiegend in den Korngrenzen einer Materialschicht eine effektive diffusionshemmende Wirkung hervorrufen kann. Überwiegend bedeutet dabei, daß eine geringe Bedeckung der Oberfläche der Materialschicht durch diffusionshemmende Substanzen zusätzlich zu der Ausbildung der Diffusionsbarriere in den Korngrenzen vorkommen kann. Bevorzugt ist die Diffusionsbarriere jedoch ausschließlich in den Korngrenzen angesiedelt.
Die Bildung der Diffusionsbarriere kann beispielsweise durch Überschreitung der Löslichkeit der entsprechenden Substanz, die die diffusionshemmende Wirkung entfaltet, in der Materialschicht erfolgen. Es kann dabei erreicht werden, daß sich Einlagerungen von Substanzen durch Präzipitieren der Substanzen in den Korngrenzen der Materialschicht bilden, die eine diffusionshemmende Wirkung gerade in den Korngrenzen entfalten. Dies ist von besonderer Bedeutung zur Unterbindung einer Diffusion von Stoffen, die gerade über diese Korngrenzen von Materialschichten diffundieren. Gerade in einem solchen Fall stellt also die Einbringung von Substanzen in die Korngrenzen einer Materialschicht eine sehr effektive Diffusionsbarriere dar.

Dabei sind die einzulagernden Substanzen entweder so zu wählen, daß sie in Bezug auf die Materialschicht kaum reagieren, also weitgehend inert sind in Bezug auf diese Materialschicht, zumindest bei den Randbedingungen, unter denen die Materialschicht und die Diffusionsbarriere hergestellt und eingesetzt werden. Die einzulagernden Substanzen können in diesem Fall in Bezug auf andere Stoffe oder Schichten durchaus reaktiv sein, z.B. in Bezug auf Hilfsschichten im Rahmen des Herstellungsprozesses oder in Bezug auf die diffundierenden Materialkomponenten, deren Diffusion unterbunden werden soll.

Andererseits können aber zur Bildung der Diffusionsbarriere auch Substanzen verwendet werden, die eine chemische Verbindung mit dem Material der Materialschicht eingehen.

Ein besonderer Vorteil der Erfindung ist, daß die vorgesehene Diffusionsbarriere nicht als zusätzliche, eigenständige Schicht aufgetragen werden muß, sondern in eine bereits vorhandene Materialschicht integriert werden kann. Die Diffusionsbarriere kann dabei z.B. direkt in eine abzuschirmende Materialschicht integriert werden, oder in eine oder mehrere Materialschichten, die der abzuschirmenden Materialschicht direkt oder indirekt benachbart sind. Dabei kann die abzuschirmende Materialschicht diejenige Schicht sein, die diffundierende Komponenten enthält oder eine Schicht, die empfindlich gegen diffundierende Komponenten ist. Es muß lediglich gewährleistet sein, daß die diffundierenden Komponenten von denjenigen Schichten oder Bereichen ferngehalten werden, die sie negtiv beeinflussen würden.
So kann die Diffusionsbarriere beispielsweise im Fall eines zuvor beschriebenden Kondensators direkt auf die dielektrische oder ferroelektrische Schicht aufgebracht werden oder auf den angrenzenden Elektroden, z.B. Platinelektroden, vorgesehen werden. Eine Anordnung einer ganzen Schicht als Diffusionsbarriere zwischen einem Dielektrikum und einer Elektrode ist bereits aus US 5,330,931 bekannt. Als einzulagernde Substanzen kann auf bekannte Materialien aus dem Stand der Technik zurückgegriffen werden, bei denen eine diffusionshemmende Wirkung festzustellen ist. Bevorzugt wird eine Einlagerung von Nitrid oder Kohlenstoff in die Materialschicht bzw. in die Korngrenzen vorgenommen.

Somit stellt die vorliegende Erfindung eine deutliche Vereinfachung dar, nachdem auf die Aufbringung und Behandlung einer zusätzlichen Schicht als Diffusionsbarriere verzichtet werden kann. Damit entstehen auch keine negativen Einflüsse durch eine solche zusätzliche Schicht. Die vorhandenen Materialschichten bleiben in ihren Eigenschaften weitestgehend unbeeinflußt durch die Erzeugung der Diffusionsbarriere. Auch die Schicht, die die Diffusionsbarriere trägt, ändert ihre Eigenschaften kaum, da nur eine eher physikalische Einlagerung der diffusionshemmenden, barrierenwirksamen Substanz erfolgt. Zur Herstellung einer erfindungsgemäßen Diffusionsbarriere wird bevorzugt eine Implantation der einzulagernden Substanz mit anschließendem Ausheilungsschritt, idealerweise durch thermische Behandlung, vorgeschlagen oder, wenn oxidierbare Materialschichten vorliegen, das nachfolgend beschriebende bevorzugte Verfahren.

Das Verfahren wird idealerweise auf eine Materialschicht angewandt, die durch ihre bauliche Anordnung die Funktion einer effektiven Diffusionsbarriere übernehmen kann und bei der die nachfolgenden Verfahrensschritte einfach umgesetzt werden können. Befindet sich beispielsweise eine oxidunempfindliche Elektrodenschicht zwischen einer oxidhaltigen Dielektrikumsschicht und einer oxidempfindlichen Leiter- oder Isolationsschich, so kann die Barriere z.B. in die Dielektrikumsschicht oder in die Elektrodenschicht integriert werden. Es wird dabei zu berücksichtigen sein, in welcher Reihenfolge die einzelnen Materialschichten aufgetragen sind bzw. werden, d.h. welche Schichtoberflächen für die Erzeugung einer Diffusionsbarriere zugänglich sind.

Auf der Oberfläche einer oxidierbaren Materialschicht, in die die Diffusionsbarriere integriert werden soll, wird eine Oxidschicht erzeugt, beispielsweise durch eine thermische Oxidation. Bevorzugt wird die Oxidschicht anschließend nitriert, wobei prinzipiell auch andere Substanzen wie oben aufgeführt in die Oxidschicht eingelagert werden können. Dabei bildet sich ein Oxinitrid auf der Oberfläche der Schicht. Gleichzeitig erfolgt eine Diffusion von Nitrid in die unter der Oxidschicht liegende, nicht-oxidierte Elektrodenschicht, wobei durch Überschreitung der Löslichkeit das Nitrid in die Korngrenzen der Elektrodenschicht präzipitiert, vor allem im Bereich direkt unter der Oxidschicht.

Schließlich entfernt man die Oxinitridschicht von der Oberfläche, wozu Standardverfahren wie insbesondere Ätzverfahren angewendet werden können. Das Nitrid verbleibt dabei in den Korngrenzen bestehen. Der Oberflächenbereich der solchermaßen behandelten Materialschicht mit dem eingelagerten Nitrid in den Korngrenzen erfüllt nun die Wirkung als Diffusionsbarriere. Da für dieses Verfahren ein Oxidationsschritt als erster Verfahrensschritt vorgesehen ist, kann das Verfahren überall dort sinnvolle Anwendung finden, wo oxidierbare Materialschichten vorliegen. In denjenigen Fällen, in denen die Materialschichten nicht oxidiert werden können, kann das Verfahren der Implantation der Substanz eine sinnvolle Alternative bieten.

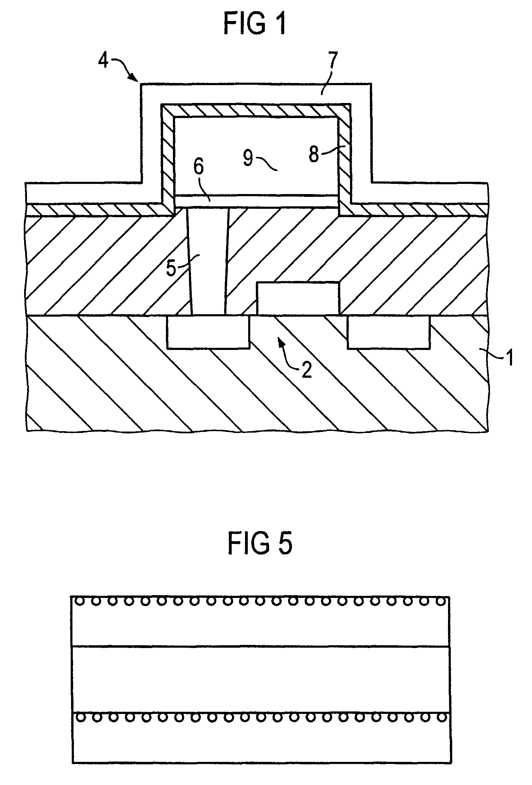

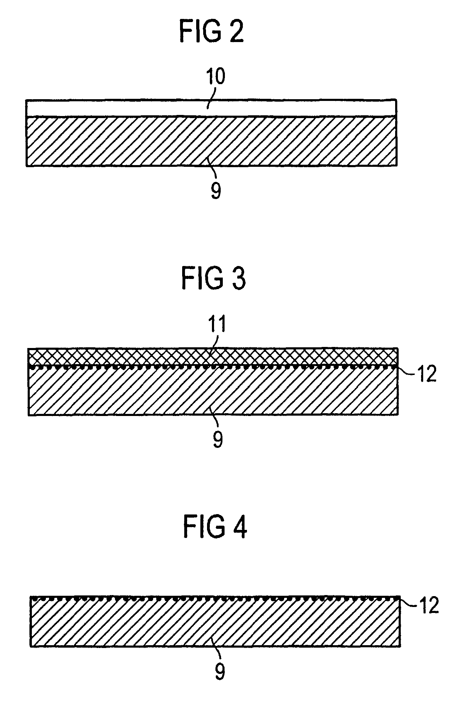

Eine spezielle Ausführungsform wird anhand der Figuren 1 bis 5 sowie der nachfolgenden speziellen Beschreibung für das Beispiel einer DRAM- oder FRAM-Speicherzelle erläutert. Es zeigt
Fig. 1: Querschnitt durch eine Speicherzelle aus Speicherkondensator und Auswahltransistor nach dem Stand der Technik
Fig. 2: Oxidierte Materialschicht
Fig. 3: Nitrierte Oxidschicht
Fig. 4: Materialschicht mit Nitrid in den Korngrenzen nach Entfernung der Oxinitridschicht
Fig. 5: Schichtanordnung des Speicherkondensators mit Diffusionsbarrieren in den Elektrodenschichten

Die Speicherzelle nach dem Stand der Technik wird gebildet durch einen Auswahltransistor 2 und einen Speicherkondensator 4, die durch eine leitende Plugverbindung 5 , beispielsweise aus Wolfram oder Polysilizium oder anderem geeigneten leitfähigen Material, miteinander verbunden sind. Der Auswahltransistor 2 ist eingebettet in ein Halbleitersubstrat 1 sowie eine erste Isolationsschicht 3 aus SiO₂, durch die auch die Plugverbindung 5 geführt wird. Auf dieser Schicht befindet sich der Speicherkondensator 4 mit zwei Elektroden 7, 9 aus einem oxidierbaren leitfähigen Material wie z.B. Ir, Ru oder Polysilizium und einem Speicherdielektrikum 8 aus SBT SrBi₂Ta₂O₉, SBTN SrBi₂(Ta₁₋ₓNbₓ)₂O₉, PZT PbₓZr₁₋ₓTiO₃ oder BST BaₓSr₁₋ₓTiO₃ oder alternativ aus Ta₂O₅, TiO₂ oder einem anderen dieleiktrischen oder ferroelektrischen Material.

Zwischen der unteren der beiden Ektroden 7 und der leitenden Plugverbindung 5 befindet sich eine Diffusionsbarrierenschicht 6. Diese verhindert vor allem eine Diffusion von Sauerstoff oder von Oxiden wie Bi₂O₃ oder PbO aus dem Speicherdielektrikum 8 durch die untere Elektrode 9 - insbesondere während der thermischen Verfahrensschritte zur Kondensatorherstellung bei Temperaturen bis 800°C - und damit eine Reaktion mit dem SiO₂ der Isolationsschicht 3, mit zwischen der Elektrode 9 und der darunter liegenden Schicht angebrachten Haftvermittlern oder gerade auch mit der leitenden Plugverbindung 5 zu nichtleitenden oder flüchtigen Oxiden wie SiO₂ oder WO₃.

Gemäß der vorliegenden Erfindung wird nun die Diffusionsbarrierenschicht 6 entbehrlich. Es erfolgt stattdessen die Einlagerung von Nitrid 12 in die Korngrenzen der unteren Elektrodenschicht 9 oder beider Elektrodenschichten 7, 9. Das Verfahren wird beispielhaft für die untere Elektrodenschicht 9 beschrieben, die aus oxidierbarem Material gewählt ist. Unter den genannten Voraussetzungen wird zunächst ein Oxidationsschritt zur Erzeugung einer Oxidschicht 10 von ca. 50 A Dicke durchgeführt, beispielsweise durch eine thermische Oxidattion bei 925°C bei einer Dauer von 60 s in einer O₂-Atmosphäre. Anschließend erfolgt eine Nitrierung der Oxidschicht 10, wodurch diese in eine Oxinitridschicht 11 umgewandelt wird. Dies kann durch Rapid Thermal Nitridation RTN bei 1050°C für eine Dauer von 30 s in einer NH3-Atmosphäre erfolgen. Das Nitrid wandert durch die Oxinitridschicht 11 weiter bis in die Elektrodenschicht 9. Dort entstehen Nitrideinlagerungen 12 in den Korngrenzen des direkt angrenzenden, nicht-oxidierten Teils der Elektrodenschicht 9, in denen das Nitrid präzipitiert. Die Nitrideinlagerung erfolgt dabei in höherer Konzentration im Bereich der Grenze zwischen Oxinitrodschicht 11 und Elektrodenschicht 9. Mit zunehmender Tiefe in die Elektrodenschicht 9 hinein nimmt die Nitridkonzentration in den Korngrenzen ab. Es kann jedoch mit den vorliegenden Verfahrenschritten erzielt werden, daß eine ausreichende Nitrideinlagerung in der Elektrodenschicht 9 bis zu einer Tiefe im Bereich von 30 bis 40 nm erzielt werden kann.

Schließlich wird die Oxidschicht 11 durch einen Ätzschritt abgelöst, z.B. durch Behandlung mit gepufferter HF (BHF), z.B. mit 40:1 BHF für eine Dauer von 70 s. Es verbleiben die Nitrideinlagerungen 12 in den Korngrenzen, die die Wirkung als diffusionshemmende Barriere erfüllen. Nach Aufbringung des Dielektrikums 8 kann die obere Elektrodenschicht 7 auf die Anordnung aufgebracht werden. In dieser oberen Elektrodenschicht kann ebenfalls eine Nitrideinlagerung 13 in den Korngrenzen vorgesehen werden, wobei die Einlagerung analog zu den Schritten des oben beschriebenen Verfahren erfolgen kann.

## Patentansprüche

1. Schichtanordnung mit einer Materialschicht (9) und einer Diffusionsbarriere (12) gegen diffundierende Materialkomponenten, die im Bereich der Schichtgrenze der Materialschicht (9) angeordnet ist,
**dadurch gekennzeichnet,**
daß die Diffusionsbarriere (12) überwiegend in den Korngrenzen der Materialschicht (9) ausgebildet ist.

2. Schichtanordnung nach Anspruch 1,
**dadurch gekennzeichnet,**
die Diffusionsbarriere (12) durch Substanzen gebildet wird, die in Bezug auf die Materialschicht (9) weitgehend inert sind.

3. Schichtanordnung nach Anspruch 1,
**dadurch gekennzeichnet,**
daß die Diffusionsbarriere (12) durch Substanzen gebildet wird, die eine chemische Verbindung mit dem Material der Materialschicht (9) eingehen.

4. Schichtanordnung nach einem der Ansprüche 1 bis 3,
**dadurch gekennzeichnet,**
daß die Materialschicht (9) durch eine Schicht gebildet wird, aus der diffundierenden Materialkomponenten entweichen können.

5. Schichtanordnung nach einem der Ansprüch 1 bis 3,
**dadurch gekennzeichnet,**
daß die Materialschicht (9) an eine weitere Materialschicht (8) oder an ein Gebiet oder einen Raum angrenzt, aus denen diffundierende Materialkomponenten entweichen können.

6. Schichtanordnung nach einem der Ansprüche 1 bis 5,
**dadurch gekennzeichnet,**
daß die Diffusionsbarriere (12) als Einlagerungen von Nitrid oder von Kohlenstoff in die Korngrenzen der Materialschicht (9) ausgebildet ist.

7. Schichtanordnung nach einem der Ansprüche 1 bis 6,
**dadurch gekennzeichnet,**
daß die Diffusionsbarriere (12) in den Korngrenzen der Materialschicht (9) zumindest bis zu einer Tiefe von 30 nm ab der Oberfläche der Materialschicht (9) ausgebildet ist.

8. Schichtanordnung nach einem der Ansprüche 1 bis 7,
**dadurch gekennzeichnet,**
daß die Schichtanordnung als Halbleiteranordnung für integrierte Schaltkreise ausgebildet ist.

9. Schichtanordnung nach Anspruch 8,
**dadurch gekennzeichnet,**
daß die Halbleiteranordnung eine Speicherzelle (2, 4) für integrierte Schaltungen mit einem Speicherkondensator (4) und einem Auswahltransistor (2) darstellt, wobei die Diffusionsbarriere (12) zwischen einem ferroelektrischen oder dielektrischen Speicherdielektrikum mit hoher Dielektrizitätskonstante (8) und einer diffusionsempfindlichen Materialschicht (5) angeordnet ist.

10. Schichtanordnung nach Anspruch 9,
**dadurch gekennzeichnet,**
daß die als Diffusionsbarriere (12) wirkenden Einlagerungen in den Korngrenzen mindestens einer der Elektrodenschichten (7, 9) oder des Speicherdielektrikums (12) des Speicherkondensators (4) angeordnet sind.

11. Schichtanordnung nach einem der Ansprüche 9 bis 10,
**dadurch gekennzeichnet,**
daß das ferroelektrische oder dielektrische Speicherdielektrikum mit hoher Dielektrizitätskonstante (8) aus SBT SrBi₂Ta₂O₉, SBTN SrBi₂(Ta₁₋ₓNbₓ)₂O₉, PZT PbₓZr₁₋ₓTiO₃ oder BST BaₓSr₁₋ₓTiO₃ besteht.

12. Verfahren zur Herstellung einer Diffusionsbarriere (12) gegen diffundierende Materialkomponenten im Bereich der Schichtgrenze einer Materialschicht (9),
**dadurch gekennzeichnet,**
daß eine Ausbildung der Diffusionsbarriere (12) überwiegend in den Korngrenzen der Materialschicht (9) erfolgt.

13. Verfahren nach Anspruch 12,
**dadurch gekennzeichnet,**
daß eine Einbringung einer Substanz in die Materialschicht (9) in einer solchen Konzentration erfolgt, daß die Löslichkeit der Substanz in der Materialschicht (9) überschritten wird.

14. Verfahren nach Anspruch 12,
**dadurch gekennzeichnet,**
daß eine Einbringung einer Substanz in die Materialschicht (9) in einer solchen Konzentration erfolgt, daß die Löslichkeit einer chemischen Verbindung aus der Substanz sowie dem Material der Materialschicht (9) in der Materialschicht (9) überschritten wird.

15. Verfahren nach einem der Ansprüche 13 bis 14,
**dadurch gekennzeichnet,**
daß eine Einlagerung von Nitrid oder Kohlenstoff in die Materialschicht (9) erfolgt.

16. Verfahren nach einem der Ansprüche 12 bis 15,
**dadurch gekennzeichnet,**
daß die Einlagerung der Substanz in die Materialschicht (9) durch einen Implantationsschritt und eine anschließende thermische Ausheilung erfolgt.

17. Verfahren nach einem der Ansprüche 12 bis 15,
**dadurch gekennzeichnet,**
daß die Einlagerung der Substanz durch folgende Schritte erfolgt:
Oxidation der Oberfläche der Materialschicht (9)
Einlagerung der Substanz in die gesamte Oxidschicht (10), bevorzugt durch chemische Verbindung der Substanz mit der Oxidschicht
Abtrag der veränderten Oxidschicht (11) auf der Oberfläche der Materialschicht (9).

18. Verfahren nach Anspruch 17,
**dadurch gekennzeichnet,**
daß die Oxidation der Materialschicht (9) durch thermische Oxidation erfolgt.

19. Verfahren nach einem der Ansprüche 17 oder 18,
**dadurch gekennzeichnet,**
daß der Abtrag der veränderten Oxidschicht (11) in einem Ätzschritt erfolgt.

20. Verfahren nach einem der Ansprüche 12 bis 19,
**dadurch gekennzeichnet,**
daß die Einlagerung der Substanz in mindestens eine Elektrodenschicht (7, 9) oder in eine Speicherdielektrikum (12) eines Speicherkondensators (4) einer integrierten Schaltung erfolgt.
